Europäisches Patentamt

European Patent Office

Office européen des brevets

(19)

(11) **EP 0 694 805 A1**

## (12) DEMANDE DE BREVET EUROPEEN

(43) Date de publication:
**31.01.1996 Bulletin 1996/05**

(51) Int Cl.$^6$: **G02F 7/00**, H03M 1/64

(21) Numéro de dépôt: **95401725.7**

(22) Date de dépôt: **20.07.1995**

(84) Etats contractants désignés:
**DE FR GB**

(30) Priorité: **29.07.1994 FR 9409436**

(71) Demandeur: **THOMSON-CSF**
**F-75008 Paris (FR)**

(72) Inventeurs:
- **Chazelas, Jean**
  **F-92402 Courbevoie Cédex (FR)**
- **Le Parquier, Guy**
  **F-92402 Courbevoie Cédex (FR)**
- **Renault, François**
  **F-92402 Courbevoie Cédex (FR)**

(74) Mandataire: **Benoit, Monique**
**F-92402 Courbevoie Cédex (FR)**

(54) **Convertisseur analogique-numérique et système de conversion analogique-numérique mettant en oeuvre ledit convertisseur**

(57) Le convertisseur analogique-numérique (1) N bits selon l'invention permet de gagner 3 bits en résolution par un codage très précis de la phase différentielle existant en sortie d'un modulateur de phase (2) électro-optique commandé par le signal électrique à convertir ($V(t)$). Les signaux optiques obtenus sont traités par un dispositif électro-optique (3) qui délivre des signaux électriques fonctions du sinus et du cosinus de la phase. Des moyens de codage (4) exploitent les symétries du cercle trigonométrique partitionné en quatre secteurs consécutifs de 0 à $2\pi$ pour convertir, indépendamment du secteur d'appartenance de la phase, la valeur absolue des signaux électriques obtenus sur (N-3) bits. Des moyens de transcodage (5) utilisent la valeur codée sur (N-3) bits du sinus et du cosinus, pour fournir sur N bits, une valeur V du signal électrique V(t), en fonction du secteur d'appartenance.

Le système de conversion selon l'invention met en oeuvre un premier convertisseur analogique-numérique N bits faisant une conversion très précise mais ambiguë du signal électrique V(t), et un deuxième convertisseur analogique-numérique permettant de lever l'ambiguïté.

FIG.1

## Description

La présente invention a pour objets une nouvelle architecture de convertisseur analogique-numérique, et un système de conversion analogique-numérique mettant en oeuvre ledit convertisseur.

Les convertisseurs analogiques-numériques, ci-après dénommés CAN, sont largement utilisés dans différents domaines techniques pour permettre le traitement en numérique d'informations saisies dans le domaine analogique, en particulier dans les télécommunications et le radar où les débits d'informations sont importants.

Les deux performances essentielles recherchées pour la fonction de CAN sont:

- une dynamique élevée pour le signal à traiter ;

- une vitesse de traitement optimale qui implique un cadencement élevé de saisie des informations, sachant par ailleurs que, pour respecter le critère de Nyquist, il convient que la fréquence d'horloge des circuits utilisés ait une valeur minimale égale au double de la fréquence la plus élevée du spectre du signal à coder.

Les difficultés rencontrées dans le domaine du codage sont liées au fait qu'il n'est pas facile d'obtenir simultanément des performances de grande dynamique et de large bande.

L'état de l'art des CAN comprend d'une part les convertisseurs purement électroniques (CAN à rampe, à approximations successives, CAN flash...), qui sont soit rapides, soit à grande dynamique, et d'autre part, les convertisseurs à effet électro-optique qui peuvent être à très large bande (1 à 1,2 GHz) mais qui ont une dynamique relativement faible (4 bits). L'article intitulé "wide-band electrooptic guided-wave analog-to-digital converters" IEEE, volume 72, n° 7, July 1984 décrit un convertisseur de ce deuxième type.

Dans ce dernier type de convertisseurs, on utilise un modulateur interférométrique de Mach-Zehnder, lequel consiste en un cristal électro-optique couplé en sortie d'un diviseur optique fournissant sur deux voies optiques de même longueur deux composantes identiques en puissance à partir d'un signal optique, et à la sortie duquel un combineur optique réalise la combinaison des signaux issus des deux voies. Le modulateur comporte en outre deux électrodes, l'une connectée à la masse, et l'autre recevant le signal analogique, par exemple une tension, que l'on souhaite convertir. L'application du signal électrique V(t) permet la création d'un champ électrique E(t). L'effet Pockels traduit le fait que l'indice de réfraction du matériau utilisé pour le cristal électro-optique varie linéairement avec ce champ électrique E(t). Les deux signaux optiques présents à la sortie des deux voies optiques, avant recombinaison, présentent, l'un par rapport à l'autre une phase différentielle φ(t) qui s'exprime par la relation :

$$\phi(t) = \frac{2\pi L}{\lambda}\, kV(t)$$

dans laquelle

λ est la longueur d'onde du signal optique en entrée de l'interféromètre ;

L est la longueur des voies optiques, ou longueur d'intéraction de la ligne électro-optique ;

k est une constante ;

V(t) est la tension analogique à coder.

Les CAN à effet électro-optique décrits jusqu'à présent dans la littérature utilisent plusieurs interféromètres de Mach-Zehnder en parallèle et de longueur d'intéraction croissant en puissance de 2, le signal V(t) à convertir étant appliqué à chacun des interféromètres. Les signaux recombinés en sortie de chaque interféromètre sont alors démodulés et comparés à un seuil de référence commun, de manière à générer une valeur binaire selon le résultat de la comparaison. L'ensemble des valeurs binaires obtenues constitue alors la valeur numérisée du signal V(t).

Une autre variante équivalente connue consiste à utiliser plusieurs interféromètres de même longueur d'intéraction en parallèle, les interféromètres étant, les uns par rapport aux autres, alimentés par des tensions proportionnelles à la tension à convertir et décroissantes en puissance de 1/2.

Dans les deux cas cependant, les convertisseurs obtenus sont à faible dynamique car il est nécessaire d'avoir un interféromètre par bit de résolution que l'on souhaite.

La présente invention a pour but de proposer une nouvelle architecture de CAN permettant d'augmenter la dynamique des convertisseurs analogiques-numériques existants, ci-après dénommés convertisseurs analogiques-numériques élémentaires, par l'utilisation de moyens électro-optiques du type interféromètre de Mach-Zehnder.

Plus précisément, la présente invention a pour premier objet un convertisseur analogique-numérique délivrant une valeur V d'un signal électrique codée sur un nombre N de bits, caractérisé en ce qu'il comporte :

- des moyens électro-optiques de modulation de phase sur une longueur d'intéraction L prédéterminée, recevant un signal d'entrée optique et le signal électrique à convertir, et délivrant un premier et un second signal optique présentant l'un par rapport à l'autre une phase différentielle variant linéairement en fonction dudit signal électrique à convertir ;

- un dispositif électro-optique recevant le premier et le second signal optique et délivrant au moins un premier et un deuxième signal électrique fonctions respectivement du sinus et du cosinus de ladite phase différentielle ;

- des moyens de codage pour extraire, sous forme numérique, les valeurs absolues du premier et du deuxième signal électrique codées sur [N-3] bits, lesdits moyens de codage ayant une dynamique maximum de codage réglée pour coder des valeurs absolues relatives à une phase différentielle comprise dans un secteur d'appartenance déterminé parmi quatre secteurs consécutifs possibles partitionnant le cercle trigonométrique sur $2\pi$ radians ;

- des moyens de transcodage délivrant ladite valeur V en codant ladite phase différentielle sur N bits à partir des valeurs absolues codées sur [N-3] bits et du secteur d'appartenance déterminé.

Selon l'invention, il est également possible, à partir de deux convertisseurs analogiques-numériques tels que décrits précédemment, d'augmenter encore la résolution d'un nombre n de bits supplémentaires, soit au total (N+n) bits, et ce, à partir de convertisseurs analogique-numérique élémentaires de (N-3) bits et de deux modulateurs électro-optiques de type Mach-Zehnder.

Pour ce faire, la présente invention a pour autre objet un système de conversion sur (N+n) bits comportant au moins un premier et un second convertisseurs analogiques-numériques tels que définis ci-dessus, caractérisé en ce que le premier convertisseur analogique-numérique, fournissant une première valeur $V_1$ codée sur N bits, est tel que ses moyens électro-optiques génèrent une première phase différentielle ($\phi_1$ (t)) susceptible de varier sur $2^n$x $(2\pi)$ radians pour une variation maximale du signal électrique à convertir, en ce que le second convertisseur, fournissant une seconde valeur $V_2$ codée sur N bits, est tel que ses moyens électro-optiques génèrent une seconde phase différentielle ($\phi_2$ (t)) susceptible de varier sur $2\pi$ radians pour ladite variation maximale du signal électrique à convertir, et en ce que le système comporte en outre un dispositif d'assemblage de la première et de la seconde valeur, délivrant une troisième valeur $V_3$ codée sur (N+n) bits.

L'invention, ainsi que ses avantages, seront mieux compris au vu de la description ci-après, faite en référence aux figures annexées :

• La figure 1 représente un synoptique d'un convertisseur analogique-numérique N-bits selon l'invention ;

• La figure 2a représente, sous forme de synoptique, un premier exemple de réalisation d'un dispositif électro-optique utilisé dans le convertisseur analogique-numérique 1 de la figure 1, pour N égal à 11 bits ;

• La figure 2b représente, sous forme de synoptique, un exemple de réalisation des moyens de codage et des moyens de transcodage placés en sortie du dispositif électro-optique de la figure 2a;

• La figure 3a représente, sous forme de synoptique, un mode de réalisation préféré d'un dispositif électro-optique utilisé dans le convertisseur analogique-numérique de la figure 1 ;

• La figure 3b représente sous forme de synoptique, un exemple de réalisation des moyens de codage et de transcodage placés en sortie du dispositif électro-optique de la figure 3a ;

• La figure 4a illustre schématiquement un premier exemple de réalisation d'un système de conversion analogique-numérique (N+n) bits selon l'invention ;

• La figure 4b illustre schématiquement un second exemple de réalisation d'un système de conversion analogique-numérique (N+n) bits selon l'invention.

Le principe de conversion analogique-numérique mis en oeuvre par le convertisseur et le système de conversion selon l'invention repose sur un codage très précis de la phase différentielle $\phi(t)$ existant entre deux signaux optiques obtenus par modulation de phase sur une longueur d'intéraction donnée, d'un signal optique d'entrée par le signal électrique V(t) à convertir. La précision sur le codage est obtenue en élaborant, à partir des signaux optiques, le sinus et le cosinus de la phase différentielle, et en exploitant les symétries du cercle trigonométrique partitionné sur $2\pi$ radians en quatre secteurs consécutifs pour coder la valeur absolue du sinus et du cosinus indépendamment du secteur d'appartenance réel de la phase.

Le codage de la phase différentielle est alors obtenu à partir des valeurs absolues codées, en tenant compte cette fois-ci du secteur d'appartenance de la phase.

Par ailleurs, en exploitant, selon l'invention, les symétries du cercle trigonométrique partitionné en quatre secteurs successifs, on montrera ci-après que le convertisseur analogique-numérique selon l'invention permet d'obtenir une valeur V du signal électrique V(t), codée sur N bits en utilisant des convertisseurs existants ne codant que sur (N-3) bits, ce qui permet un gain total en résolution de 3 bits.

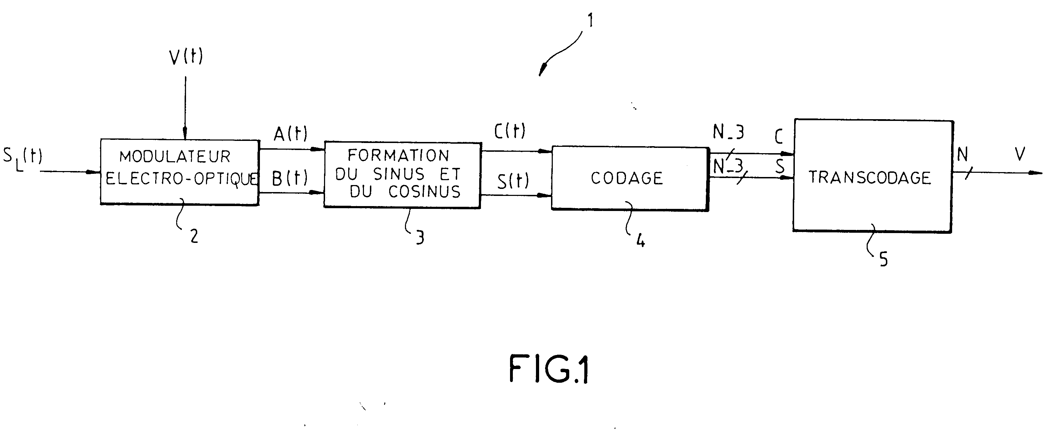

La figure 1 illustre, sous forme de synoptique simplifié, les moyens constitutifs d'un convertisseur analogique-numérique 1 selon l'invention :

Conformément à la figure 1, le convertisseur analogique-numérique 1 comporte tout d'abord des moyens électro-optiques 2 réalisant, sur une longueur d'intéraction L prédéterminée, une modulation de phase à partir d'un signal d'entrée optique $S_L(t)$ et du signal électrique V(t) que l'on souhaite convertir sur N bits. Ces moyens sont par exemple un interféromètre de Mach-Zehnder tel que décrit précédemment, à ceci près que les sorties des deux voies optiques ne sont pas recombinées.

Si le signal d'entrée optique $S_L(t)$ s'exprime sous la forme :

$$S_L(t) = I_0 \cos\omega_0 t$$

où $I_0$ est l'intensité maximale du signal, et $\omega_0$ est la pulsation du signal, les moyens électro-optiques 2 délivrent un premier signal $A(t)$ et un second signal $B(t)$ optiques s'exprimant sous la forme :

$$\begin{cases} A(t) = \dfrac{I_o}{2}\cos(\omega_o t + \varphi(t)) \\ B(t) = \dfrac{I_o}{2}\cos(\omega_o t) \end{cases}$$

où $\phi(t)$ représentent la phase différentielle entre les deux signaux optiques $A(t)$ et $B(t)$.

Pour ne pas avoir d'ambiguïté sur la mesure de la phase différentielle $\phi(t)$, et donc sur la conversion, du signal analogique V(t), on choisit de préférence des moyens électro-optiques 2 dont la longueur L des voies optiques est telle que, pour une variation maximum du signal à convertir, la phase différentielle ait varié de $2\pi$ radians.

Le convertisseur analogique-numérique 1 comporte par ailleurs un dispositif électro-optique 3 permettant, à partir des deux signaux optiques $A(t)$, $B(t)$, de générer au moins un premier signal électrique $S(t)$ fonction du sinus de la phase différentielle, et un deuxième signal électrique $C(t)$ fonction du cosinus de cette même phase.

Des moyens de codage 4 réalisent un codage sur (N-3) bits des valeurs absolues des signaux $S(t)$ et $C(t)$. Les moyens de codage ont une dynamique maximum de codage réglée pour coder des valeurs absolues S, C relatives à une phase différentielle $\phi(t)$ appartenant à un seul secteur parmi les quatre secteurs d'appartenance possibles partitionnant le cercle trigonométrique sur $2\pi$ radians. Les moyens de codage 4 délivrent alors les valeurs absolues C et S du cosinus et du sinus codées sur (N-3) bits à des moyens de transcodage 5 qui délivrent à leur tour, comme il sera expliqué par la suite, la valeur V codée sur N bits du signal électrique V(t).

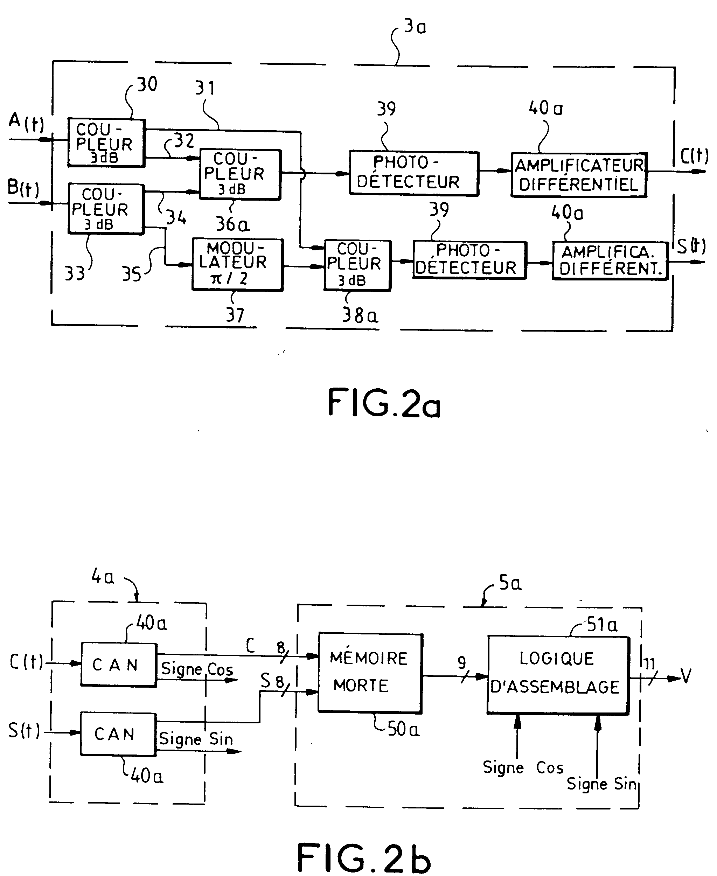

Les figures 2a et 2b illustrent un premier exemple de réalisation du dispositif électro-optique et des moyens de codage et de transcodage de la figure 1. Cette réalisation suppose que l'on dispose à l'origine de convertisseurs analogiques-numériques élémentaires codant sur (N-3) bits la valeur absolue des signaux à leur entrée, ainsi que le signe de l'entrée sur un bit. Pour fixer les idées, on supposera dans la suite que l'on dispose de CAN élémentaires de 8 bits plus 1 bit de signe.

Le dispositif électro-optique 3a de la figure 2a reçoit en entrée le premier et le second signal optique $A(t)$, $B(t)$, issus des moyens électro-optiques 2 (voir figure 1) et délivre en sortie le premier et le deuxième signal électrique $S(t)$ et $C(t)$, dépendant respectivement du sinus et du cosinus de la phase différentielle, en utilisant les éléments optiques ou électro-optiques suivants:

Les signaux $A(t)$ et $B(t)$ sont tout d'abord divisés en deux signaux optiques équi-puissance par l'intermédiaire de deux coupleurs optiques à 3dB 30, 33 utilisés en diviseurs. En reprenant les notations utilisées précédemment, les signaux optiques sur les voies optiques de sortie 31 et 32 du diviseur 30 peuvent s'exprimer sous la forme :

$$\frac{I_0}{4}\cos(\omega_0 t + \phi(t))$$

De même, les signaux optiques sur les voies optiques de sortie 34 et 35 du diviseur 33 s'expriment sous la forme :

$$\frac{I_0}{4}\cos\omega_0 t$$

Un premier coupleur optique 36a à 3dB, utilisé en combineur, combine alors l'une des sorties 34 du coupleur diviseur 33 avec l'une des sorties 32 du coupleur diviseur 30, et délivre un signal optique de la forme :

$$\frac{I_0}{4}[\cos(\omega_0 t + \phi(t)) + \cos\omega_0 t]$$

La deuxième sortie optique 35 du diviseur 33 alimente un modulateur de phase optique réalisant un déphasage de $\frac{\pi}{2}$ sur le signal, et délivrant un signal optique de la forme :

$$-\frac{I_0}{4}\sin\omega_0 t$$

Ce dernier signal est ensuite combiné avec la sortie 31 du premier diviseur 30 à l'aide d'un second combineur optique 38a à 3dB, de manière à fournir un signal optique s'exprimant sous la forme :

$$\frac{I_0}{4}[\cos(\omega_0 t - \phi(t)) - \sin\omega_0 t]$$

Les signaux optiques en sortie des deux combineurs à 3dB 36a et 38a sont ensuite transformés en signaux électriques en passant chacun dans un photodétecteur 39 réalisant une détection quadratique.

Le calcul montre que les signaux électriques du photodétecteur relié au combineur 36a et du photodétecteur relié au combineur 38a sont à un facteur de proportionnalité près, de la forme :

$$\begin{cases} 1 + \cos\varphi(t) \\ 1 + \sin\varphi(t) \end{cases}$$

Un amplificateur différentiel 40a en sortie de chaque photodétecteur 33 permet, de façon connu par l'homme de l'art, de supprimer la composante continue, de manière à fournir le premier signal $S(t)$ et le deuxième signal $C(t)$ électriques respectivement fonction du sinus et du cosinus de la phase différentielle $\phi(t)$.

Conformément à la figure 2b, les moyens de codage 4a, dans leur premier exemple non limitatif de réalisation, reçoivent les deux signaux électriques $C(t)$ et $S(t)$ issus du dispositif électro-optique 3a de la figure 2b et comportent les éléments suivants:

Deux CAN élémentaires 40a capables de coder le signe reçoivent en entrée les signaux électriques $C(t)$ et $S(t)$ et délivrent une valeur sur 9 bits, dont 8 bits représentent la valeur absolue C ou S de l'entrée, et un bit représente le signe. Selon l'invention, les CAN élémentaires 40a sont réglés, de façon connue, pour fournir 256 valeurs absolues codées possibles, pour un signal d'entrée représentatif d'un cosinus ou d'un sinus compris entre 0 et 1, relatif à une phase différentielle comprise dans l'un quelconque des quatre secteurs d'appartenance du cercle trigonométrique.

Les moyens de transcodage 5a comportent une mémoire morte 50a à double adressage, les adresses étant constituées par les valeurs absolues codées C et S issues des deux CAN élémentaires 40a. Cette mémoire 50a comporte les valeurs pré-enregistrées sur 9 bits représentatives de la phase différentielle $\phi(t)$ correspondant aux différentes valeurs possibles de sinus et de cosinus sur un secteur. Le secteur d'appartenance réel de la phase différentielle est donné par les deux bits de signe du sinus et du cosinus.

Des moyens d'assemblage 51a permettent alors de construire sur 11 bits la valeur codée de la phase différentielle, les neuf bits de poids faibles étant constitués par la valeur codée lue dans la mémoire 50a, et les bits de poids forts étant constitués par les bits de signe du sinus et du cosinus. A titre d'exemple illustratif du transcodage précédent, une phase différentielle légèrement inférieure à $\pi$ radians correspondra à une valeur S égale à "00000000", un bit de signe du sinus égal à "1", une valeur C égale à "11111111" et un bit de signe du cosinus égal à "0". Par conséquent, la valeur issue de la mémoire sera "111111111" et la valeur issue de l'assemblage sera "01111111111".

Dans toute la description faite précédemment en référence aux figures 2a et 2b, on a supposé que l'on disposait de CAN élémentaires capables de coder le signe du signal qu'ils avaient en entrée, c'est-à-dire, soit du premier signal électrique $S(t)$, soit du deuxième signal électrique $C(t)$.

Une variante du convertisseur analogique-numérique, dans laquelle on dispose de CAN élémentaires ne codant que la valeur absolue des signaux $S(t)$ et $C(t)$, par exemple sur huit bits, va maintenant être décrite :

Dans cette variante, le dispositif électro-optique 3 de la figure 1 délivre, en plus du signal $S(t)$ et du signal $C(t)$, un troisième et un quatrième signal électrique respectivement égaux en valeur absolue à $S(t)$ et $C(t)$, mais de signes opposés. Nous noterons par la suite -$S(t)$ et -$C(t)$ ces signaux supplémentaires.

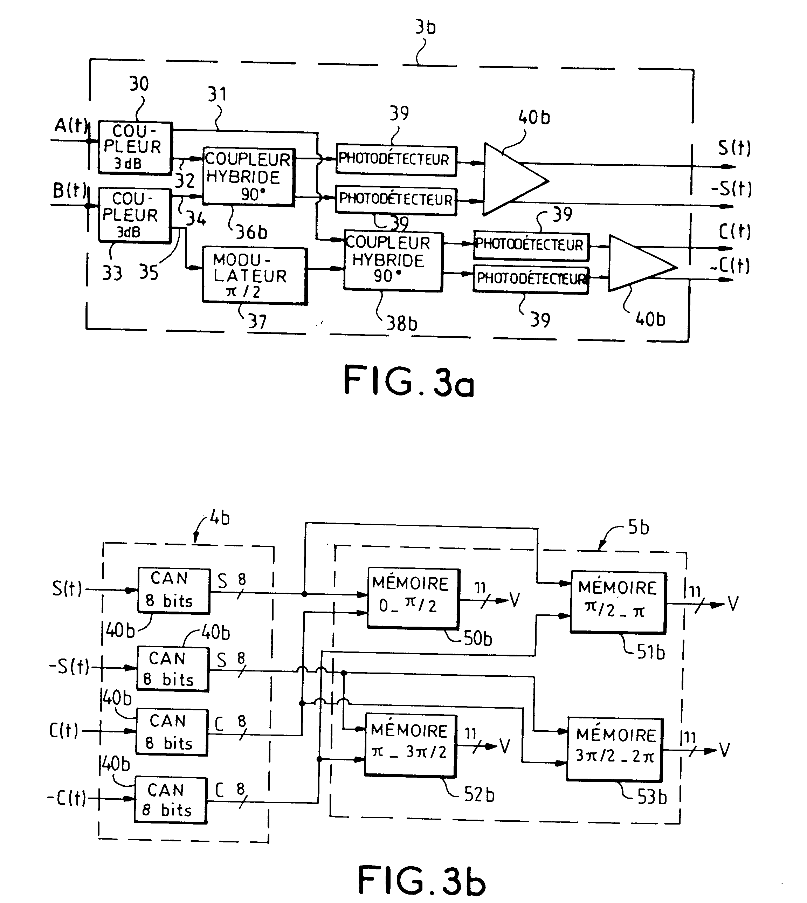

La figure 3a illustre, sous forme de synoptique simplifié, les éléments constitutifs d'un dispositif électro-optique 3b permettant d'élaborer, à partir des signaux optiques $A(t)$ et $B(t)$ délivrés par les moyens optiques 2 (voir figure 1), les quatre signaux électriques $S(t)$, -$S(t)$, $C(t)$, -$C(t)$ :

Dans la partie optique du dispositif 3b, constitué de coupleurs optiques et du modulateur optique, les éléments identiques au dispositif 3a de la figure 2a portent les mêmes références et ne seront pas redécrits.

Par contre, les deux coupleurs 36a et 38a à 3dB de la figure 2a ont ici été remplacés par deux coupleurs optiques hybrides à $\frac{\pi}{2}$ référencés 36b et 38b. Le premier coupleur combiner 36b délivre deux signaux optiques de sortie qui peuvent s'exprimer par les relations :

$$(1)\begin{cases} \dfrac{I_o}{4}\Big[\cos\big(\omega_o t + \varphi(t)\big) - \sin\,\omega_o t\Big] \\[2em] \dfrac{I_o}{4}\Big[\cos\big(\omega_o t + \varphi(t)\big) + \sin\,\omega_o t\Big] \end{cases}$$

et le second coupleur hybride combiner 38b délivre également deux signaux optiques de sortie qui peuvent s'exprimer par les relations :

$$(2)\begin{cases} \dfrac{I_o}{4}\Big[\cos\big(\omega_o t + \varphi\big) - \cos\,\omega_o t\Big] \\[2em] \dfrac{I_o}{4}\Big[\cos\big(\omega_o t + \varphi\big) + \cos\,\omega_o t\Big] \end{cases}$$

Un couple de photodétecteurs 39 reçoit les deux signaux optiques du système de relations (1), les sorties des photodétecteurs constituant les deux entrées d'un amplificateur différentiel 40b dont les deux sorties correspondent au premier et au troisième signal électrique $S(t)$ et -$S(t)$.

De manière analogue, l'association série d'un second couple de photodétecteurs 39 et d'un amplificateur différentiel 40b permet de délivrer le deuxième et le quatrième signal électrique $C(t)$ et -$C(t)$ à partir des signaux optiques du système de relations (2).

Les moyens de codage utilisés en sortie du dispositif électro-optique 3b de la figure 3a sont représentés schématiquement sur la figure 3b :

Ils comportent quatre CAN élémentaires 40b capables de coder uniquement la valeur absolue des signaux d'entrée, à savoir $S(t)$,-$S(t)$,$C(t)$,-$C(t)$. Comme précédemment, les CAN 40b ont une dynamique maximum de codage réglée de manière à coder, par exemple sur 8 bits, les valeurs absolues comprises entre 0 et 1, pour un unique secteur d'appartenance.

Les moyens de transcodage 5b comportent quatre mémoires mortes à double adressage contenant chacune des valeurs pré-enregistrées de la phase différentielle $\phi(t)$ codée sur 11 bits, en fonction du secteur d'appartenance de cette phase différentielle. En fait, les valeurs contenues d'une mémoire à l'autre diffèrent simplement par les deux bits de poids forts qui indiquent le secteur d'appartenance ("00" pour $\phi(t)$ appartenant à 0-$\pi$/2, "01" pour $\phi(t)$ appartenant à $\pi$/2 -$\pi$, "10" pour $\phi(t)$ appartenant

à π- 3π/2, "11" pour $\phi(t)$ appartenant à 3π/2 - 2π).

Les différentes mémoires sont adressées par les valeurs S et C provenant de CAN élémentaires différents :

La première mémoire 50b, relative au secteur d'angle compris entre 0 et π/2 est adressée par les valeurs S et C relatives au codage respectivement du premier et du deuxième signal $S(t)$ et $C(t)$.

La deuxième mémoire 51b , relative au secteur d'angle compris entre π/2 et π, est adressée par les valeurs S et C relatives au codage respectivement du premier et du quatrième signal, $S(t)$ et $-C(t)$.

La troisième mémoire 52b, relative au secteur d'angle compris entre π et 3π/2, est adressée par les valeurs S et C relatives au codage respectivement du troisième et du quatrième signal, $-S(t)$ et $-C(t)$.

Enfin, la quatrième mémoire 53b, relative au secteur d'angle compris entre 3π/2 et 2π, est adressée par les valeurs S et C relatives au codage respectivement du troisième et du deuxième signal, $-S(t)$ et $C(t)$.

D'après tout ce qui précède, le convertisseur analogique-numérique N bits selon l'invention permet donc d'augmenter de 3 bits la résolution des CAN élémentaires existants, en utilisant un modulateur électro-optique, au moins deux CAN élémentaires de (N-3) bits, un dispositif de codage et des moyens de transcodage particuliers.

Pour obtenir un fonctionnement optimal d'un tel convertisseur, certaines précautions peuvent être avantageusement prises :

Le signal optique $S_L(t)$ en entrée des moyens électro-optiques 2, est de préférence fourni par une source laser, sous forme d'impulsions dont la durée est compatible avec le temps de transit du signal électrique V(t) dans les vois optiques des moyens 2, par exemple de l'ordre de 0,5 nanosecondes. La puissance optique de la source laser est choisie de manière à fournir, en sortie de photodétecteurs, une tension efficace située N-3 bits au-dessus du bruit dans la bande passante du signal d'entrée V(t).

Par ailleurs, le signal d'entrée V(t) peut transiter dans un échantillonneur-bloqueur avant d'être appliqué sur les moyens électro-optiques 2, ceci afin de stabiliser en amplitude le niveau du signal V(t) pendant le temps d'intéraction avec le signal laser $S_L(t)$. Cet échantillonneur-bloqueur doit travailler au même rythme que le convertisseur analogique-numérique et posséder la même dynamique, soit N bits.

Les photodétecteurs utilisés dans le dispositif électro-optique 3, 3a ou 3b doivent avoir de préférence une bande passante instantanée compatible de la bande passante du signal à traiter.

En outre, il peut être nécessaire de réaliser une stabilisation des éléments analogiques et des CAN élémentaires :

Pour ce faire, on peut utiliser la table de transcodage pour déterminer l'amplitude ρ du vecteur de composantes $(S(t), C(t))$ et corriger certaines non-linéarités : en effet, si tout était parfait, cette amplitude ρ devrait être constante quelle que soit la phase différentielle et la fonction $\rho=f(\phi)$ devrait être un cercle. Or, il peut arriver que l'amplitude ρ soit trop grande, ou trop faible, auquel cas il faut agir sur le gain général du convertisseur, par exemple en modifiant la puissance du laser. La fonction $\rho=f(\phi)$ peut également avoir l'allure d'une ellipse qu'il faut corriger en venant jouer sur les gains relatifs des amplificateurs permettant d'obtenir les différents signaux électriques fonctions du sinus et du cosinus. En résumé, une analyse de la fonction décrivant la variation de ρ en fonction de la phase différentielle peut permettre, par contre-réaction, de corriger certains défauts.

Enfin, il peut être intéressant de réduire la longueur d'interaction L des moyens électro-optiques 2 utilisés pour réaliser une modulation de phase et créer des signaux déphasés. Pour ce faire, on peut utiliser un interféromètre de Mach-Zehnder dont la première électrode reçoit le signal V(t) à convertir, et la deuxième électrode reçoit -V(t), au lieu d'être reliée à la masse comme précédemment.

Ainsi, on peut montrer que la phase différentielle de deux signaux optiques obtenus en sortie des moyens électro-optiques 2 est égale à $2\phi(t)$. Une attaque symétrique des électrodes permet donc de diviser la longueur d'interaction par 2.

Dans ce qui suit, nous allons décrire un système de conversion utilisant en parallèle deux convertisseurs analogiques-numériques N bits du type de celui décrit précédemment, et permettant de gagner en résolution n bits supplémentaires, c'est-à-dire permettant la conversion du signal électrique V(t) sur N+n bits.

Pour ce faire, le système de conversion selon l'invention est tel que l'un des deux convertisseurs analogiques-numériques utilisés, appelé convertisseur fin, est réglé de façon à ce que les moyens électro-optiques qui lui sont propres génèrent une phase différentielle $\phi_1(t)$ dont la variation maximale, correspondant à une variation maximale du signal d'entrée V(t) à convertir, soit égale à $2^n \times (2\pi)$ radians , alors que le deuxième convertisseur, appelé convertisseur de levée d'ambiguïté, est réglé de manière à générer une phase différentielle $\phi_2(t)$ dont la variation maximale, correspondant à la même variation maximale du signal d'entrée V(t), soit égale à $2\pi$ radians.

Deux modes de réalisation possibles permettent d'avoir un tel système :

Dans un premier cas, si L est la longueur d'intéraction qu'il faut donner aux moyens électro-optiques de modulation de phase du convertisseur fin pour avoir une variation maximale de la phase différentielle de $2^n \times (2\pi)$ radians, on fixe la valeur de la longueur d'intéraction relative au convertisseur de levée d'ambiguïté à

$$\frac{L}{2^n}$$

. Dans ce cas, les deux convertisseurs sont alimentés simultanément par le même signal électrique V(t).

Une variante de réalisation consiste à utiliser deux convertisseurs identiques en tout point, le convertisseur fin recevant le signal électrique V(t), et le convertisseur de levée d'ambiguïté recevant un signal électrique égal à

$$\frac{V(t)}{2^n}$$

. Cette variante n'est possible que dans la mesure où

$$\frac{V(t)}{2^n}$$

est supérieur au bruit dans la bande à traiter.

Dans tous les cas, les deux convertisseurs utilisés reçoivent en entrée le même signal optique $S_L(t)$.

Chaque convertisseur fournit une valeur codée sur N bits, de la manière précédemment décrite. La valeur finale $V_3$ numérisant le signal d'entrée V(t) comprend (N+n) bits composés de N bits fournis par le convertisseur fin pour les bits de poids faibles, et de n bits de poids forts correspondant aux bits de poids faibles fournis par le convertisseur de levée d'ambiguïté.

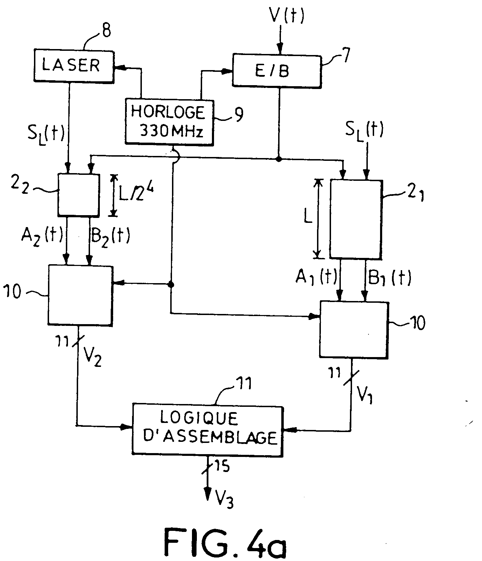

Sur la figure 4a, on a représenté schématiquement un premier exemple de réalisation d'un système de conversion sur 15 bits, dans lequel les longueurs d'interaction relatives au premier convertisseur (convertisseur fin) et au deuxième convertisseur (convertisseur de levée d'ambiguïté) sont différentes :

Sur cette figure un module laser 8 fournit le signal optique d'entrée $S_L(t)$ simultanément aux moyens électro-optiques $2_1$ et $2_2$ respectivement du premier et du second convertisseurs. Ces derniers reçoivent également le signal électrique à convertir V(t), ayant transité préférentiellement au préalable dans un échantillonneur-bloqueur 7. Les moyens électro-optiques $2_1$ du convertisseur fin ont une longueur d'interaction L déterminée de manière à ce que la phase différentielle $\phi_1(t)$ existant entre les deux signaux $A_1(t)$, $B_1(t)$ en sortie de ces moyens, subisse une variation de $2^5 \pi$ radians pour une variation maximale du signal V(t).

Par ailleurs, les moyens électro-optiques $2_2$ du convertisseur de levée d'ambiguïté ont une longueur d'interaction fixée à

$$\frac{L}{2^4}$$

, de manière à ce que la phase différentielle $\phi_2(t)$ existant entre les deux signaux optiques $A_2(t)$, $B_2(t)$ issus de ces moyens subisse une variation de $2 \pi$ radians pour la variation maximale du signal V(t). Les signaux $A_1(t)$, $B_1(t)$ d'une part, et $A_2(t)$, $B_2(t)$ d'autre part, sont traités dans un bloc 10 comportant le dispositif électro-optique 3, les moyens de codage 4 et les moyens de transcodage 5 de la figure 1, de manière à délivrer une première valeur $V_1$ et une deuxième valeur $V_2$ codant respectivement sur 11 bits, la phase différentielle $\phi_1(t)$ et la phase différentielle $\phi_2(t)$. Le premier convertisseur permet de faire un codage très précis du signal électrique V(t), avec cependant une ambiguïté sur le nombre de tours effectués par la phase différentielle $\phi_1(t)$. Le second convertisseur permet de lever cette ambiguïté. Un dispositif d'assemblage 11 recevant les valeurs $V_1$ et $V_2$, délivre la valeur $V_3$ représentative du signal V(t) codé sur 15 bits, les 11 bits de poids faibles étant constitués pour la première valeur V, issue du convertisseur fin, et les 4 bits de poids forts étant constitués des 4 bits de poids faibles de la deuxième valeur $V_2$. Le fonctionnement de l'ensemble du système est synchronisé par une même horloge 9, par exemple à une fréquence de 330 MHz.

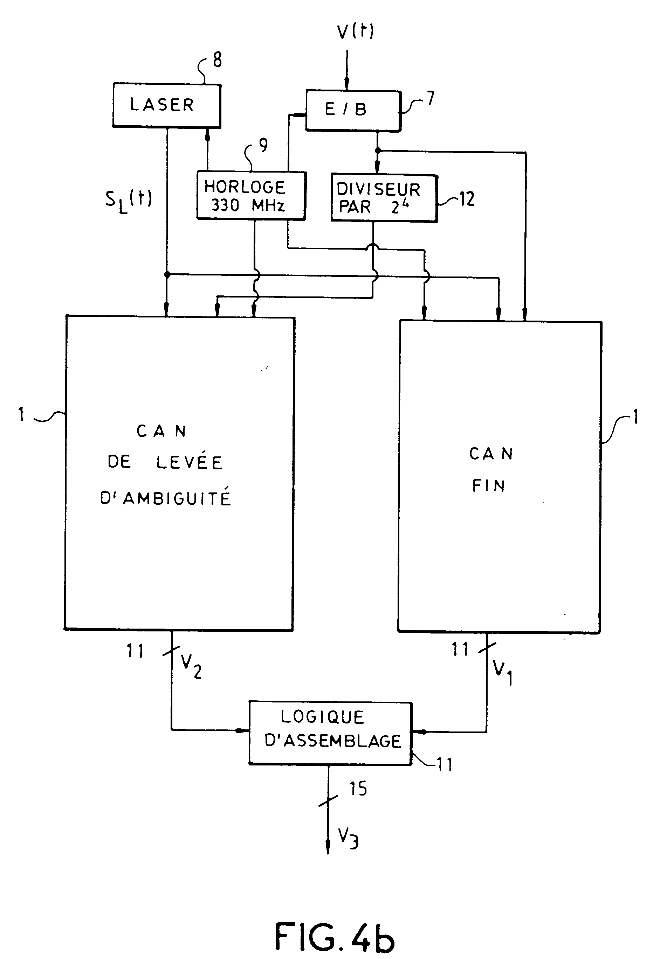

La figure 4b illustre un deuxième exemple de réalisation d'un système de conversion sur 15 bits selon l'invention, dans lequel les deux convertisseurs 1 utilisés sont identiques. Le convertisseur fin reçoit en entrée le signal électrique V(t) qui a transité au préalable dans l'échantillonneur-bloqueur 7, alors qu'un module 12 permet de diviser le signal V(t) par $2^4$ avant d'appliquer le résultat de la division au convertisseur de levée d'ambiguïté.

Dans le système de conversion selon les figures 4a et 4b, la conversion se fait au rythme de l'horloge 9, c'est-à-dire, dans les exemples numériques choisis, à 330 MHz. On peut augmenter la fréquence de codage en multiplexant temporellement plusieurs systèmes de conversion selon l'invention.

A l'heure actuelle, il est par exemple possible, grâce à l'invention, de réaliser un système de codage sur 15 bits fonctionnant à 2 GHz à partir de six systèmes de conversion multiplexés comportant des convertisseurs élémentaires de 8 bits fonctionnant à 330 MHz.

## Revendications

1. Convertisseur analogique-numérique (1) délivrant une valeur V d'un signal électrique ($V(t)$) codée sur un nombre N de bits, caractérisé en ce qu'il comporte :

   - des moyens électro-optiques (2) de modulation de phase sur une longueur d'intéraction L prédéterminée, recevant un signal d'entrée optique ($S_L(t)$) et le signal électrique à convertir ($V(t)$), et délivrant un premier et un second signal optique ($A(t)$, $B(t)$) présentant l'un par rapport à l'autre une phase différentielle ($\phi(t)$) variant linéairement en fonction dudit signal électrique à convertir ;

   - un dispositif électro-optique (3; 3a; 3b) recevant le premier et le second signal optique ($A(t)$, $B(t)$) et délivrant au moins un premier et un deuxième signal électrique ($S(t)$, $C(t)$) fonctions respectivement du sinus et du cosinus de ladite phase différentielle ;

   - des moyens (4 ; 4a ; 4b) de codage pour extraire, sous forme numérique, les valeurs absolues (S, C) du premier et du deuxième signal électrique codées sur [N-3] bits, lesdits moyens de codage ayant une dynamique maximum de codage réglée pour coder des valeurs absolues (S, C) relatives à une phase différentielle ($\phi(t)$) comprise dans un secteur d'appartenance déterminé parmi quatre secteurs consécutifs possibles partitionnant le cercle trigonométrique sur $2\pi$ radians ;

- des moyens (5; 5a; 5b) de transcodage délivrant ladite valeur V en codant ladite phase différentielle ($\phi(t)$) sur N bits à partir des valeurs absolues (S, C) codées sur [N-3] bits, et du secteur d'appartenance déterminé.

2. Convertisseur analogique-numérique selon la revendication 1 caractérisé en ce que ledit dispositif électro-optique (3; 3a) comporte :

• un premier coupleur diviseur optique à 3dB (30) recevant le premier signal optique ($A(t)$) et comportant une première (31) et une seconde (32) voie optique de sortie ;

• un second coupleur diviseur optique à 3dB (33) recevant le second signal optique ($B(t)$) et comportant une première (34) et une seconde (35) voie optique de sortie ;

• un modulateur de phase à
$$\frac{\pi}{2}$$
(37) relié à la seconde (35) voie optique de sortie du second coupleur diviseur (33) ;

• un premier coupleur combineur optique à 3dB (36a) relié à la première (34) et à la seconde (32) voie optique respectivement du second (33) et du premier (30) coupleur diviseur ;

• un second coupleur combineur optique à 3dB (38a) relié à la première (31) voie optique de sortie du premier coupleur diviseur (30) et à la sortie du modulateur de phase à
$$\frac{\pi}{2}$$
(37) ;

• deux photodétecteurs (39) reliés respectivement en sortie du premier (36a) et du second (38a) coupleur combineur à 3dB.

• deux amplificateurs différentiels (40a) en sortie des deux photodétecteurs (39) et délivrant lesdits premier et deuxième signaux électriques.

3. Convertisseur analogique-numérique selon l'une des revendications 1 ou 2, caractérisé en ce que les moyens de codage (4, 4a) comportent deux convertisseurs analogiques-numériques (40a) élémentaires recevant le premier et le deuxième signal électrique ($S(t)$, $C(t)$) et délivrant d'une part, sur [N-3] bits, les valeurs absolues codées (S, C) et d'autre part, sur un bit, les signes du premier et du deuxième signal électrique.

4. Convertisseur analogique-numérique selon la revendication 3, caractérisé en ce que les moyens de transcodage comportent :

- une mémoire à double adressage (50a) délivrant, sur [N-2] bits, une valeur codée pré-enregistrée de la phase différentielle ($\phi(t)$) indépendamment du secteur d'appartenance , à partir de deux adresses constituées par lesdites valeurs absolues codées (S, C) ;

- des moyens d'assemblage (51a) délivrant la valeur V codée sur N bits, les [N-2] bits de poids faibles étant constitués par la valeur codée délivrée par la mémoire à double adressage, et les 2 bits de poids forts étant constitués des bits relatifs aux signes du premier et du deuxième signal électrique, issus des convertisseurs analogiques-numériques élémentaires (40a).

5. Convertisseur analogique-numérique selon la revendication 1, caractérisé en ce que le dispositif électro-optique (3,3b) délivre en outre un troisième et quatrième signal électrique ($-S(t),-C(t)$)respectivement égal en valeur absolue, au premier et au deuxième signal électrique, et de signe opposés.

6. Convertisseur analogique-numérique selon la revendication 5 caractérisé en ce que ledit dispositif électro-optique (3, 3b) comporte :

- Un premier coupleur diviseur optique à 3dB (30) recevant le premier signal optique ($A(t)$) et comportant une première (31) et une seconde (32) voie optique de sortie ;

- Un second coupleur diviseur optique à 3dB (33) recevant le second signal optique ($B(t)$) et comportant une première (34) et une seconde (35) voie optique de sortie ;

- Un modulateur de phase
$$\frac{\pi}{2}$$
(37) relié à la seconde (35) voie optique de sortie du second coupleur diviseur (33) ;

- un premier coupleur optique hybride à
$$\frac{\pi}{2}$$

(36b) relié à la première (34) et la seconde (32) voie optique de sortie respectivement du second (33) et du premier (30) coupleur diviseur, et délivrant deux signaux de sortie ;

- un second coupleur optique hybride à

$$\frac{\pi}{2}$$

(38b) relié à la première (31) voie optique de sortie du premier coupleur diviseur (30) et à la sortie du modulateur de phase

$$\frac{\pi}{2}$$

(37), et délivrant des signaux de sortie;

- un premier couple de photodétecteurs (39) recevant chacun l'un des deux signaux de sortie du premier coupleur optique hybride à

$$\frac{\pi}{2}$$

(36b) et délivrant leur sortie à un amplificateur différentiel (40b) à deux entrées et à deux sorties correspondant au premier et au troisième signal électrique ($S(t)$,-$S(t)$) ;

- un second couple de photodétecteurs (39) recevant chacun l'un des deux signaux de sortie du second coupleur optique hybride à

$$\frac{\pi}{2}$$

(38b) et délivrant leur sortie à un amplificateur différentiel (40b) à deux entrées et à deux sorties correspondant au deuxième et au quatrième signal électrique ($C(t)$, -$C(t)$) ;

7. Convertisseur analogique-numérique selon l'une quelconque des revendication 5 ou 6 caractérisé en ce que les moyens de codage (4, 4b) comportent quatre convertisseurs analogiques-numériques (40b) élémentaires recevant chacun l'un des quatre signaux électriques ($S(t)$, -$S(t)$;$C(t)$, -$C(t)$) issus du dispositif électro-optique (3, 3b) et délivrant une valeur absolue (S, C) codée sur [$N$-3] bits.

8. Convertisseur analogique-numérique selon la revendication 7, caractérisé en ce que les moyens de transcodage comportent quatre mémoires à double adressage contenant chacune des valeurs préenregistrées codées sur N bits de la phase différentielle ($\phi(t)$) en fonction du secteur d'appartenance de ladite phase différentielle, à savoir :

- une première mémoire (50b) relative à une phase différentielle comprise entre 0 et $\pi/2$, adressée par les sorties des deux convertisseurs analogique-numérique élémentaires codant le premier et le deuxième signal électrique ($S(t)$, $C(t)$) ;

- une deuxième mémoire (51b) relative à une phase différentielle comprise entre $\pi/2$ et $\pi$, adressée par les sorties des deux convertisseurs analogique-numérique élémentaires codant le premier et le quatrième signal électrique ($S(t)$, -$C(t)$) ;

- une troisième mémoire (52b) relative à une phase différentielle comprise entre $\pi$ et $3\pi/2$, adressée par les sorties des deux convertisseurs analogique-numérique élémentaires codant le troisième et le quatrième signal électrique (-$S(t)$, -$C(t)$) ;

- une quatrième mémoire (53b) relative à une phase différentielle comprise entre $3\pi/2$ et $2\pi$, adressée par les sorties des deux convertisseurs analogique-numérique élémentaires codant le deuxième et le troisième signal électrique ($C(t)$, -$S(t)$).

9. Convertisseur analogique-numérique selon l'une quelconque des revendications précédentes, caractérisé en ce que les moyens électro-optiques (2) comportent un interféromètre de Mach-Zehnder comprenant deux électrodes, une première électrode étant reliée à la masse et une seconde électrode recevant le signal électrique à convertir.

10. Convertisseur analogique-numérique selon l'une quelconque des revendications 1 à 8, caractérisé en ce que les moyens électro-optiques (2) comportent un interféromètre de Mach-Zehnder comprenant deux électrodes, une première électrode recevant le signal électrique à convertir, et une seconde électrode recevant l'opposé du signal électrique à convertir.

11. Convertisseur analogique-numérique selon l'une quelconque des revendications précédentes, caractérisé en ce que la longueur d'interaction L est déterminée de manière à ce que la phase différentielle subisse une variation de $2\pi$ radians pour une variation maximale du signal électrique à convertir.

12. Système de conversion sur (N+n) bits comportant au moins un premier et un second convertisseurs analogiques-numériques tels que définis dans les revendications 1 à 10, caractérisé en ce que le premier convertisseur analogique-numérique, fournissant une première valeur $V_1$ codée sur N bits, est tel que ses moyens électro-optiques ($2_1$) génèrent une première phase différentielle ($\phi_1(t)$) susceptible de varier sur $2^n \times (2\pi)$ radians pour une variation maximale du signal électrique à convertir, en ce que le second convertisseur, fournissant une seconde valeur $V_2$ codée sur N bits, est tel que ses moyens électro-optiques ($2_2$) génèrent une seconde phase

différentielle ($\phi_2$ ($t$)) susceptible de varier sur 2 $\pi$ radians pour ladite variation maximale du signal électrique à convertir, et en ce que le système comporte en outre un dispositif d'assemblage (11) de la première et de la seconde valeur, délivrant une troisième valeur $V_3$ codée sur (N+n) bits.

13. Système de conversion selon la revendication 12, caractérisé en ce que, la longueur d'interaction relative au premier convertisseur étant égale à L, la longueur d'interaction relative au second convertisseur est fixée à

$$\frac{L}{2^n}$$

.

14. Système de conversion selon l'une quelconque des revendications 11 et 12, caractérisé en ce que le dispositif d'assemblage (11) délivre une troisième valeur $V_3$ dont les N bits de poids faibles sont égaux aux N bits de la première valeur $V_1$, et les n bits de poids forts sont égaux aux n bits de poids faibles de la seconde valeur $V_2$.

FIG.1

S_L(t) → MODULATEUR ELECTRO-OPTIQUE (2) ← V(t)
→ A(t), B(t) → FORMATION DU SINUS ET DU COSINUS (3)
→ C(t), S(t) → CODAGE (4)
→ N_3 C, N_3 S → TRANSCODAGE (5) → N → V

1

FIG.2a

FIG.2b

FIG. 3a

FIG.3b

FIG. 4a

FIG.4b

Office européen
des brevets

**RAPPORT DE RECHERCHE EUROPEENNE**

Numero de la demande

EP 95 40 1725

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | FR-A-2 691 265 (DEUTSCHE AEROSPACE) <br> * le document en entier * <br> --- | 1 | G02F7/00 <br> H03M1/64 |
| A | US-A-4 502 037 (LE PARQUIER ET AL) <br> * le document en entier * <br> --- | 1 | |
| A | US-A-4 694 276 (RASTEGAR) <br> * abrégé * <br> --- | 1 | |
| A,D | PROCEEDINGS OF THE IEEE, <br> vol.72, no.7, Juillet 1984 <br> pages 802 - 819 <br> BECKER ET AL 'Wide-Band Electrooptic <br> Guided-Wave Analog-to-Digital Converters' <br> * le document en entier * <br> ----- | 1 | |
| | | | **DOMAINES TECHNIQUES RECHERCHES (Int.Cl.6)** <br><br> G02F <br> H03M |

Le présent rapport a été établi pour toutes les revendications

| Lieu de la recherche | Date d'achèvement de la recherche | Examinateur |
|---|---|---|
| LA HAYE | 19 Septembre 1995 | Guivol, Y |

EPO FORM 1503 03.82 (P04C02)